(19)

Europäisches
Patentamt

European
Patent Office

Office européen
des brevets

(11)  **EP 3 963 349 B1**

(12)  **EUROPÄISCHE PATENTSCHRIFT**

(45) Veröffentlichungstag und Bekanntmachung des
Hinweises auf die Patenterteilung:
**26.10.2022  Patentblatt 2022/43**

(21) Anmeldenummer: **20732094.6**

(22) Anmeldetag: **30.04.2020**

(51) Internationale Patentklassifikation (IPC):
**G01R 31/42** *(2006.01)*  **G01R 31/28** *(2006.01)*

(52) Gemeinsame Patentklassifikation (CPC):
**G01R 31/42; G01R 31/2846**

(86) Internationale Anmeldenummer:
**PCT/AT2020/060174**

(87) Internationale Veröffentlichungsnummer:
**WO 2020/223748 (12.11.2020 Gazette 2020/46)**

(54) **BATTERIESIMULATOR MIT KOMPENSATIONSIMPEDANZ**

BATTERY SIMULATOR HAVING COMPENSATION IMPEDANCE

SIMULATEUR DE BATTERIE AVEC IMPÉDANCE DE COMPENSATION

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **03.05.2019  AT 504012019**

(43) Veröffentlichungstag der Anmeldung:
**09.03.2022  Patentblatt 2022/10**

(73) Patentinhaber: **Kristl, Seibt & Co. Gesellschaft
M.B.H.
8052 Graz (AT)**

(72) Erfinder:
 • **HAIDINGER, Thomas
   8075 Hart bei Graz (AT)**
 • **GÖLDNER, Arthur
   9583 Faak am See (AT)**
 • **AUER, Christian
   8020 Graz (AT)**

(74) Vertreter: **SONN Patentanwälte OG
Riemergasse 14
1010 Wien (AT)**

(56) Entgegenhaltungen:
**DE-A1-102011 054 370    DE-A1-102012 217 973
KR-B1- 100 652 728**

 • **"Stabilizing Fast Transient Response Power
   Supply/Load Circuits", , 1. Januar 2007
   (2007-01-01), XP055144579, Gefunden im
   Internet:
   URL:http://www.tek.com/dl/_2870_Stabilizin
   g_AN.pdf [gefunden am 2014-10-06]**
 • **BUCCOLINI LUCA ET AL: "Cell Battery Emulator
   for Hardware-in-the-Loop BMS Test", 2018 IEEE
   INTERNATIONAL CONFERENCE ON
   ENVIRONMENT AND ELECTRICAL
   ENGINEERING AND 2018 IEEE INDUSTRIAL AND
   COMMERCIAL POWER SYSTEMS EUROPE
   (EEEIC / I&CPS EUROPE), IEEE, 12. Juni 2018
   (2018-06-12), Seiten 1-5, XP033422269, DOI:
   10.1109/EEEIC.2018.8493731 [gefunden am
   2018-10-16]**

**EP 3 963 349 B1**

**Beschreibung**

Die Erfindung betrifft eine Vorrichtung zum Testen, insbesondere hochfrequenten Testen, eines Prüflings, beispielsweise einer elektrischen Maschine oder eines Umrichters, aufweisend:

-   eine Simulationseinheit zur Simulation eines elektrischen Energiespeichers mit Hilfe eines Simulationsmodells und
-   eine elektrische Verbindungsleitung, über welche der Prüfling mit der Simulationseinheit verbindbar ist, wobei die Vorrichtung eine Kompensationsimpedanz zur Kompensation einer Impedanz zufolge einer Leitungsinduktivität der Verbindungsleitung aufweist.

Des Weiteren betrifft die Erfindung ein Verfahren zum Testen, insbesondere hochfrequenten Testen, eines Prüflings, beispielsweise einer elektrischen Maschine oder eines Umrichters, bei dem der Prüfling über eine elektrische Verbindungsleitung mit einer Simulationseinheit verbunden wird, wobei die Simulationseinheit einen elektrischen Energiespeicher mit Hilfe eines Simulationsmodells simuliert, wobei eine Kompensationsimpedanz zur Kompensation einer Impedanz zufolge einer Leitungsinduktivität der Verbindungsleitung verwendet wird.

Die Spannung an einem Energiespeicher, wie zum Beispiel einer Batterie oder einem Akkumulator, ist nicht konstant, sondern hängt vom Verlauf des aktuellen und des vergangenen Stromflusses, vom Ladezustand, von der Temperatur, von der Alterung des Energiespeichers und von vielen weiteren Dingen ab. Möchte man einen batterie- oder akkubetriebenen Prüfling, zum Beispiel eine elektrische Antriebseinheit eines Fahrzeugs oder einen Umrichter, am Prüfstand realistisch betreiben, könnte man eine reale Batterie verwenden. Der Zeitaufwand, um die Batterie vor jedem Versuch in den gewünschten Zustand (Ladezustand, Temperatur, Alterung usw.) zu bringen wäre allerdings enorm und nicht immer zuverlässig reproduzierbar. Deswegen wird am Prüfstand üblicherweise eine Simulationseinheit, ein sogenannter Batteriesimulator bzw. Batterieemulator, eingesetzt. Die Simulationseinheit stellt grob gesprochen im Wesentlichen eine steuerbare Spannungsquelle dar, die eine vom Simulationsmodell berechnete Spannung ausgibt und dem Prüfling zur Verfügung stellt. Das Simulationsmodell gibt dabei auch die Impedanz der Simulationseinheit vor.

Um die meist schwere und empfindliche Simulationseinheit nicht bei jeder Prüfung neu platzieren und einrichten zu müssen, wird am Prüfstand in der Regel eine flexible, mehrere Meter lange Verbindungsleitung verwendet. Über diese Verbindungsleitung wird der Prüfling während des Tests mit der Simulationseinheit verbunden und mit Strom bzw. Spannung versorgt.

Aus dem Stand der Technik sind Batteriesimulatoren unter anderem aus WO 2013/174967 A1 und DE 296 21 472 U1 bekannt.

Aus dem Artikel "Stabilizing Fast Transient Response Power Supply/Load Circuits", mit der Nummer 2870 aus der Reihe "Application Note Series" von Keithley aus dem Jahr 2007 ist ein Batteriesimulator zum Betreiben bzw. Testen von portablen Geräten bekannt. Um einem Prüfling eine bestimmte Ausgangsspannung zur Verfügung zu stellen, ist eine Regelung mit einer Rückkoppelung über Messleitungen vorgesehen. Es wird beschrieben, dass die Ausgangsspannung des Batteriesimulators aufgrund von Reaktanzen zu oszillieren beginnen und instabil werden kann, wenn transiente Schaltvorgänge auftreten. Zur Erhöhung der Stabilität werden mehrere Methoden vorgeschlagen. Unter anderem kann ein Kompensationsnetzwerk vorgesehen sein. Durch diese Maßnahme soll die Stabilität der Schaltung erhöht werden. Die Kompensationskondensatoren und die Kompensationswiderstände des Kompensationsnetzwerkes schließen den Rückkoppelungskreis und sind damit nicht parallel zum Prüfling angeordnet. Mithilfe des Kompensationsnetzwerks soll ein Bypass für die Leitungsinduktivität und die Kapazität des Rückkoppelungsnetzwerks für Frequenzen f>fres realisiert werden.

Weitere Energieversorgungsvorrichtungen sind aus KR 100 652 728 B1, DE 10 2012 217 973 A1, DE 10 2011 054 370 A1 und Buccolini Luca et al: "Cell Battery Emulator for Hardware-in-the-Loop BMS Test", 2018 IEEE INTERNATIONAL CONFERENCE ON ENVIRON-MENT AND ELECTRICAL ENGINEERING AND 2018 IEEE INDUSTRIAL AND COMMERCTAL POWER SYSTEMS EUROPE (EEEIC / I&CPS EUROPE), IEEE, 12. Juni 2018 (2018-06-12), Seiten 1-5, bekannt.

Moderne Antriebseinheiten werden häufig an schnell schaltenden Umrichtereinheiten betrieben. Zu Testzwecken werden diese häufig an Prüfständen mit Vorrichtungen der eingangs erwähnten Art getestet. Problematisch ist jedoch, dass insbesondere bei hohen Schaltfrequenzen die dem Prüfling tatsächlich zur Verfügung gestellte Spannung zum Teil beträchtlich von den durch das Simulationsmodell vorgegebenen Spannung abweicht und hochfrequente Spannungsschwankungen auftreten können. Dies kann dazu führen, dass der Prüfling wegen Über- oder Unterspannung abschaltet oder dass der Prüfling beschädigt wird. Eine Kompensation dieser Abweichung durch das Simulationsmodell ist bislang, nicht zuletzt auf Grund der dazu theoretisch notwendig Spannungserhöhung durch die Simulationseinheit, nicht möglich. Tests an schnell schaltenden Prüflingen sind daher nicht zuverlässig durchführbar.

Es ist daher Aufgabe der vorliegenden Erfindung, die Nachteile des Standes der Technik zu lindern oder gar gänzlich zu beseitigen. Insbesondere ist es Aufgabe der vorliegenden Erfindung, die Abweichungen zwischen der dem Prüfling zur Verfügung gestellten Spannung und der durch das Simulationsmodell vorgegebenen Spannung zu minimieren bzw. zu beseitigen und dadurch eine zuverlässige Prüfung auch bei hohen Schaltfrequenzen der Prüflinge zu ermöglichen.

Gelöst wird diese Aufgabe in durch die Merkmale des kennzeichnenden Teils des Anspruch 1. Die Vorrichtung zeichnet sich demnach dadurch aus, dass die Kompensationsimpedanz derart angeordnet ist, dass sie in einem angeschlossenen Zustand des Prüflings elektrisch parallel zum Prüfling angeordnet ist.

Vorteilhafterweise kann mit Hilfe der Kompensationsimpedanz der Einfluss des induktiven, frequenzabhängigen Anteils der Leitungsimpedanz der Verbindungsleitung kompensiert werden, sodass auch bei höheren Frequenzen ein zuverlässiges Testen eines Prüflings an der Vorrichtung ermöglicht wird. "Höhere Frequenzen" bzw. "Hochfrequenz" bedeuten in diesem Zusammenhang Frequenzen der Spannung bzw. des Stroms von zumindest 300 Hz, insbesondere zumindest 1000 Hz, vorzugsweise zumindest 3000 Hz.

Die Erfindung beruht dabei auf der Erkenntnis, dass Schwankungen in der Spannung und die Abweichungen zwischen den durch das Simulationsmodell vorgegebenen Spannung und der tatsächlich dem Prüfling am Ende der Verbindungsleitung zur Verfügung gestellten Spannung primär auf den Widerstands- und Induktivitätsbelag der Verbindungsleitung zurückzuführen sind. Der kapazitive Belag kann dabei ob seines geringen Einflusses vernachlässigt werden. Der Widerstands- und der Induktivitätsbelag der Verbindungsleitung bilden die Leitungsimpedanz der Verbindungsleitung und führen ohne jegliche Kompensation dazu, dass die vom Prüfling im verbundenen Zustand aus "sichtbare" Quellimpedanz der Vorrichtung erhöht wird und diese daher von der Impedanz der Simulationseinheit abweicht. Die "sichtbare" Quellimpedanz des Prüflings wird dabei durch eine Impedanz der Simulationseinheit und die Leitungsimpedanz der Verbindungleitung gebildet. Je länger dabei die Verbindungsleitung ist, desto größer ist diese Abweichung. Auf Grund der Leitungsinduktivität bzw. der Impedanz zufolge der Leitungsinduktivität erhöht sich mit zunehmender Frequenz der Betrag der Leitungsimpedanz und damit der Betrag der Quellimpedanz. Dies führt, wie oben geschildert, insbesondere bei hohen Frequenzen zu Problemen, da sich dem Prüfling, nicht wie eigentlich gewünscht, die Impedanz der Simulationseinheit, sondern die vergrößerte Quellimpedanz darstellt.

Durch die erfindungsgemäße Kompensationsimpedanz kann der beschriebenen Problematik entgegengewirkt werden. Insbesondere ist es mit der erfindungsgemäßen Kompensationsimpedanz, wie bereits erwähnt, möglich, durch die Wahl geeigneter Parameter den Einfluss der Leitungsinduktivität der Verbindungsleitung zu minimieren oder gänzlich zu beseitigen. Dies erfolgt dadurch, dass durch die Kompensationsimpedanz die vom Prüfling im verbundenen Zustand sichtbare Quellimpedanz angepasst, d.h. verändert wird. Der Wert der Quellimpedanz kann dabei an einen Vorgabewert angepasst werden, welcher beispielsweise dem Simulationsmodell entstammen kann. Beispielsweise kann die Quellimpedanz derart verändert werden, dass die Quellimpedanz der (ursprünglichen) Impedanz der Simulationseinheit entspricht. Der Einfluss der Verbindungsleitung wird dabei eliminiert. Die Vorrichtung wirkt in diesem Fall für den Prüfling so, als würde er direkt ohne Verbindungsleitung an die Simulationseinheit angeschlossen sein. Mit anderen Worten ist es möglich, durch Verwendung der Kompensationsimpedanz und gegebenenfalls Änderung der ursprünglichen Impedanz der Simulationseinheit eine Quellimpedanz der Vorrichtung einzustellen, die dem ursprünglich gewünschten, durch das Simulationsmodell vorgegebenen Wert der Impedanz der Simulationseinheit entspricht. Falls notwendig oder zweckdienlich, kann auch eine Änderung, insbesondere eine Reduktion, der Impedanz der Simulationseinheit vorgenommen werden.

Zweckmäßigerweise kann die Kompensationsimpedanz einen ohmschen Anteil und einen kapazitiven Anteil aufweisen. Durch die Kompensationsimpedanz und gegebenenfalls gleichzeitige Änderung, insbesondere Reduktion, der Impedanz der Simulationseinheit kann zum einen der Einfluss des Leitungswiderstandes der Verbindungsleitung, der bereits einer Frequenz von 0 Hz auftritt und über den gesamten Frequenzbereich annähernd konstant ist, und zum anderen der Einfluss der Leitungsinduktivität, die insbesondere bei Frequenzen über 300 Hz an Einfluss gewinnt, kompensiert werden.

Bei der Simulationseinheit, welche auch als Batteriesimulator oder Batterieemulator bezeichnet wird, kann eine Recheneinheit, wie etwa einen Computer oder eine Mikroprozessoreinheit, aufweisen. Die Recheneinheit ist in der Lage, das Simulationsmodell auszuführen bzw. zu berechnen und eine Spannung und/oder einen Strom gemäß dem Simulationsmodell an einem Ausgang der Simulationseinheit auszugeben. Hierdurch können Netzwerke, bestehend aus Widerständen, Induktivitäten und Kapazitäten rasch nachgebildet werden. Die Simulationseinheit stellt somit eine steuerbzw. regelbare Spannungsquelle dar. Die Bauteilwerte hängen vom Betriebszustand des simulierten Energiespeichers ab und werden durch das Simulationsmodell vorgegeben. Das Simulationsmodell gibt somit die Impedanz der Simulationseinheit vor. Die Verbindungsleitung ist mit dem Ausgang der Simulationseinheit verbindbar. Als Verbindungsleitung kann ein mehrpoliges Kabel, beispielsweise ein zweipoliges Kabel, vorzugsweise mit geringer Leitungsinduktivität, vorgesehen sein.

Es ist vorgesehen, dass die Kompensationsimpedanz derart angeordnet ist, dass sie in einem angeschlossenen Zustand des Prüflings elektrisch parallel zum Prüfling angeordnet ist. Dadurch wird ein möglicher negativer Einfluss der Kompensationsimpedanz bei niedrigen Frequenzen vermieden.

Eine einfache Anpassung der Quellimpedanz ergibt sich, wenn die Kompensationsimpedanz an einem dem Prüfling zugewandten Ende der Verbindungsleitung, vorzugsweise zwischen dem Prüfling zugewandten Ende der Verbindungsleitung und dem Prüfling, insbesondere in einer Verbindungseinheit, angeordnet ist. Durch die Anordnung in der Nähe des Prüflings können die Einflüsse der Verbindungsleitung besonders effizient kompensiert werden. Die Verbindungseinheit kann zumindest eine Schraubklemme, eine Stecker- und/oder Kupplungseinheit aufweisen, mit der der Prüfling direkt verbunden werden kann.

Zur Erzeugung eines ohmschen und eines kapazitiven Anteils kann die Kompensationsimpedanz einen ohmschen Kompensationswiderstand und einen Kompensationskondensator aufweisen, wobei der Kompensationswiderstand und der Kompensationskondensator vorzugsweise elektrisch in Serie geschaltet sind. Durch den Kompensationskondensator ergibt sich der Vorteil, dass der Einfluss des Kompensationswiderstands auf die Quellimpedanz bei niedrigen Frequenzen gering gehalten werden kann.

Um Veränderungen des Simulationsmodells und andere Einflüsse, wie etwa Temperaturschwankungen, jederzeit berücksichtigen zu können, kann es vorteilhaft sein, wenn als ohmscher Kompensationswiderstand ein verstellbarer Widerstand und/oder wenn als Kompensationskondensator ein verstellbarer Kondensator vorgesehen ist. Der Kompensationswiderstand und der Kompensationskondensator können dabei beispielsweise mechanisch verstellbar sein. Zum Beispiel kann als Kompensationswiderstand ein Potentiometer vorgesehen sein. Es können aber auch schaltbare Widerstandsnetzwerke für den Kompensationswiderstand bzw. schaltbare Kondensatornetzwerke für den Kompensationskondensator vorgesehen sein. Diese können manuell und/oder elektronisch angesteuert werden.

In einer besonders bevorzugten Ausführungsform kann vorgesehen sein, die Kompensationsimpedanz eine aus einer Leitungsimpedanz der Verbindungsleitung und der Impedanz der Simulationseinheit gebildete Quellimpedanz derart anpasst, dass die Quellimpedanz einem ohmschen Vorgabewiderstand entspricht. Die vom Prüfling aus sichtbare Quellimpedanz ist demnach (unter Vernachlässigung kapazitiver Anteile) ein rein ohmscher Widerstand. Für den Prüfling wirkt die Vorrichtung also so, als ob er an einen Energiespeicher mit einer ohmschen Quellimpedanz angeschlossen wäre. Zusätzlich kann zweckmäßigerweise auch eine Anpassung, insbesondere eine Reduktion, der Impedanz der Simulationseinheit vorgenommen werden, um die Quellimpedanz zu reduzieren. Bei dem Vorgabewiderstand kann es sich um einen allgemeinen ohmschen Widerstand oder eine ursprünglich durch das Simulationsmodell vorgegebene rein ohmsche Impedanz der Simulationseinheit handeln.

In einer Ausführungsform kann vorgesehen sein, dass der Wert des Kompensationswiderstands im Wesentlichen dem Wert des Vorgabewiderstands entspricht.

Vorteilhaft ist dabei, wenn die Impedanz der Simulationseinheit einem ohmschen Innenwiderstand entspricht, der gemäß der Formel $R_I = R_S - R_L$ dimensioniert ist, wobei $R_S$ den ohmschen Vorgabewiderstand und $R_L$ einen ohmschen Leitungswiderstand der Verbindungsleitung bezeichnet. Hierdurch kann vorteilhafterweise der Leitungswiderstand kompensiert werden.

Weiters ist es günstig, wenn der Kompensationskondensator gemäß der Formel $C_P = L_L/(R_P^2)$ dimensioniert ist, wobei $L_L$ eine Leitungsinduktivität der Verbindungsleitung und $R_P$ den Kompensationswiderstand bezeichnet.

Durch die oben genannte Wahl der Parameter erfolgt auf vorteilhafte Weise eine Anpassung der Quellimpedanz an einen Vorgabewert, und das nicht nur bei einer bestimmten Frequenz, sondern über den gesamten Frequenzbereich. Zusammenfassend kann die Quellimpedanz auf besonders effiziente Weise angepasst werden, wenn die Impedanz der Simulationseinheit $R_I = R_S - R_L$ entspricht, der Kapazitätswert des Kompensationskondensators $C_P = L_L/(R_P^2)$ beträgt und der Wert des Kompensationswiderstands im Wesentlichen dem ohmschen Vorgabewiderstand entspricht. Dann entspricht auch die Quellimpedanz vorteilhafterweise dem Vorgabewiderstand.

Des Weiteren wird die oben gestellte Aufgabe durch ein Verfahren nach Anspruch 9 gelöst. Bei dem Verfahren ist erfindungsgemäß vorgesehen, dass die Kompensationsimpedanz elektrisch parallel zum Prüfling angeordnet ist.

Die in Bezug auf die Vorrichtung beschriebenen Vorteile und Merkmale sind uneingeschränkt auch auf das Verfahren anwendbar.

Im Folgenden wird die Erfindung an Hand von Figuren näher beschrieben, auf die sie allerdings nicht beschränkt sein soll.

Fig. 1 zeigt eine vereinfachte Darstellung der erfindungsgemäßen Vorrichtung mit einem an die Vorrichtung angeschlossenen Prüfling.

Fig. 2 zeigt ein Ersatzschaltbild der erfindungsgemäßen Vorrichtung mit einem an die Vorrichtung angeschlossenen Prüfling.

Fig. 3 zeigt einen Amplitudengang der Quellimpedanz ohne Kompensation und den Amplitudengang der Impedanz der Simulationseinheit.

Fig. 4 zeigt ein Ersatzschaltbild der erfindungsgemäßen Vorrichtung mit einem an die Vorrichtung angeschlossenen Prüfling und einer Kompensationsimpedanz $Z_K$.

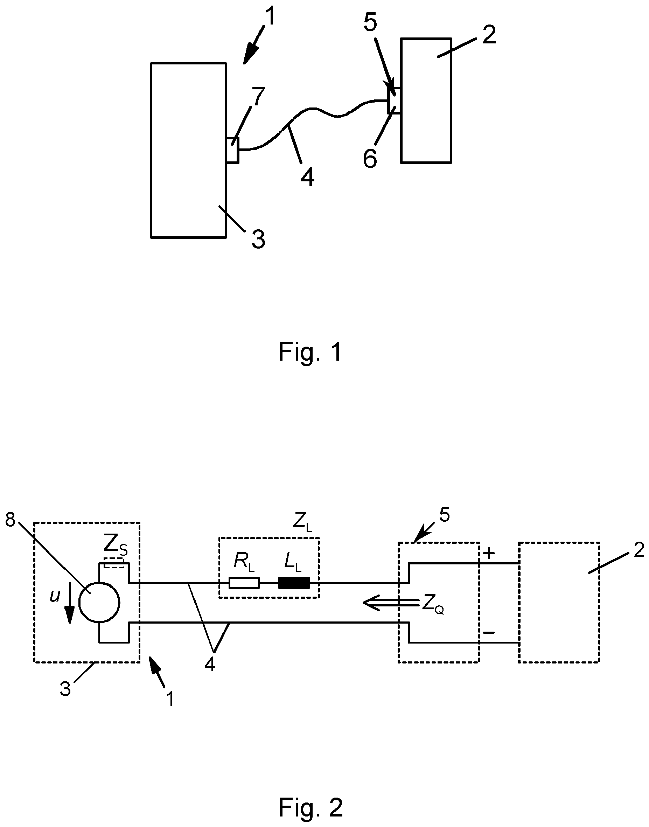

Fig. 1 zeigt eine vereinfachte Darstellung der erfindungsgemäßen Vorrichtung 1, an welche ein Prüfling 2 in Form einer elektrischen Antriebseinheit angeschlossen ist. Die Vorrichtung 1 weist eine Simulationseinheit 3 zur Simulation eines elektrischen Energiespeichers, beispielsweise einer Batterie oder eines Akkumulators, und eine elektrische Verbindungsleitung 4 auf, an deren Ende sich eine Verbindungseinheit 5 mit einer Stecker- und/oder Kupplungseinheit 6 befindet. Es können aber auch Schraubklemmen an der Verbindungseinheit 5 vorgesehen sein. Die Stecker- und/oder Kupplungseinheit 6 ist an den Prüfling 2 angeschlossen und stellt eine elektrische Verbindung zwischen dem Prüfling 2 und der Simulationseinheit 3 her.

Die Simulationseinheit 3 kann durch einen Computer oder Mikroprozessor gebildet sein und über einen Ausgang 7 Strom- und Spannung gemäß einem Simulationsmodell zur Verfügung stellen. Strom und Spannung wird über die Verbindungsleitung 4 an den Prüfling 2 übertragen. Die Simulationseinheit 3 entspricht somit im Wesentlichen einer steuerbaren Spannungsquelle.

Derartige Simulationseinheiten 3 werden auch als Batteriesimulatoren oder Batterieemulatoren bezeichnet und ermöglichen es, den Betrieb eines Prüflings 2 an einem Energiespeicher zu simulieren. Mit Hilfe eines Simulationsmodells können unterschiedliche Betriebspunkte eines Energiespeichers simuliert werden, ohne dass ein realer Energiespeicher verwendet werden muss. Die Verwendung eines realen Energiespeichers würde einen enormen Aufwand darstellen, da dieser zunächst in den gewünschten Betriebspunkt (Temperatur, Ladung etc.) gebracht werden müsste. Aus diesem Grund haben sich Simulationseinheiten 3 für Testzwecke durchgesetzt.

Vielfach werden moderne elektrische Antriebseinheiten an schnell schaltenden Umrichtern, d.h. bei hohen (Grund-)Frequenzen von Strom und Spannung, betrieben. Problematisch ist dabei jedoch, dass insbesondere bei hohen Frequenzen die dem Prüfling 2 zur Verfügung gestellte Spannung von der durch das Simulationsmodell vorgegebenen Spannung am Ausgang 7 der Simulationseinheit 3 mitunter massiv abweicht.

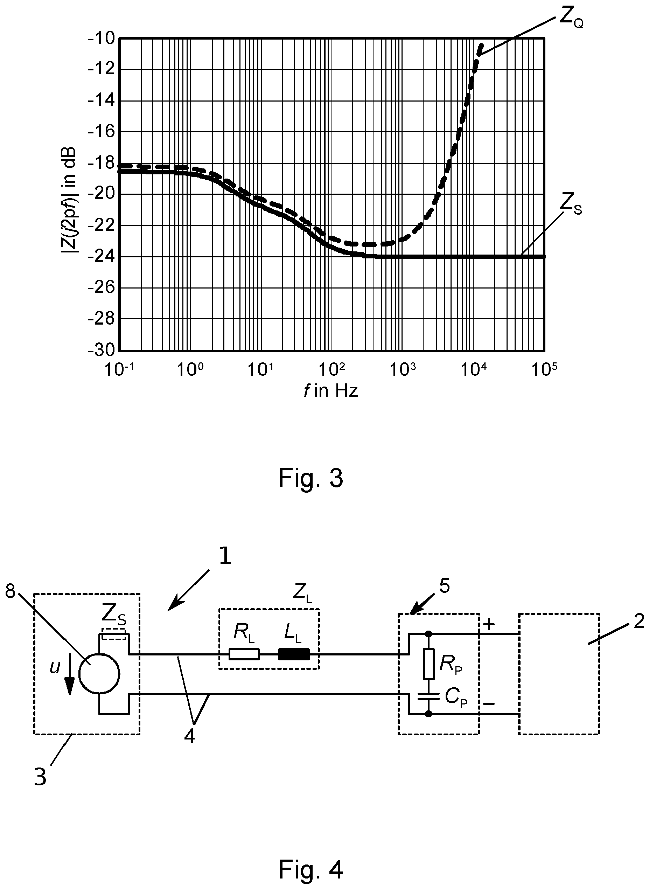

Für dieses Problem konnte folgende Ursache identifiziert werden, die an Hand der Figuren 2 und 3 veranschaulicht werden soll:

Fig. 2 zeigt ein Ersatzschaltbild der erfindungsgemäßen Vorrichtung 1 mit einem an die Vorrichtung 1 angeschlossenen Prüfling 2. Die Verbindungsleitung 4 weist im Wesentlichen einen Widerstandsbelag und einen Induktivitätsbelag auf, welche in Fig. 2 als konzentrierte Bauteile $R_L$ und $L_L$ dargestellt werden. Dabei bezeichnet $R_L$ den Leitungswiderstand und $L_L$ die Leitungsinduktivität der Verbindungsleitung 4. Ein allfälliger kapazitiver Belag wird für die weitere Veranschaulichung ob seines geringen Einflusses vernachlässigt. Der tatsächliche Wert der Bauteile $R_L$ und $L_L$ hängt von der Geometrie der Verbindungsleitung 5 ab. Der erwartbare Wert des Leitungswiderstands $R_L$ liegt im Bereich von einigen mΩ, der erwartbare Wert der Leitungsinduktivität $L_L$ liegt im Bereich von einigen μH. Der Leitungswiderstand $R_L$ und die Leitungsinduktivität $L_L$ bilden zusammen (unter Vernachlässigung des kapazitiven Anteils) eine Leitungsimpedanz $Z_L$. Die Simulationseinheit 3 ist als Spannungsquelle 8 dargestellt und weist eine (durch eine gestrichelte Linie dargestellte) Impedanz $Z_S$ auf, welche sich aus dem verwendeten Simulationsmodell ergibt bzw. von diesem vorgegeben wird.

Der Widerstandsbelag und der Induktivitätsbelag haben nun eine Auswirkung auf die Impedanz der Vorrichtung 1, die der Prüfling "sieht". Diese Impedanz wird als Quellimpedanz $Z_Q$ bezeichnet und setzt sich zunächst im Wesentlichen aus der Impedanz $Z_S$ der Simulationseinheit 3 und der Leitungsimpedanz $Z_L$ zusammen. Durch den Widerstandsbelag und den Induktivitätsbelag weicht die vom Prüfling "gesehene" Quellimpedanz $Z_Q$ von der Impedanz $Z_S$ der Simulationseinheit 3, insbesondere bei Frequenzen >300 Hz, ab. Dies ist in Fig. 3 ersichtlich, welche den Amplitudengang in dB der sich dem Prüfling 2 darstellenden Quellimpedanz $Z_Q$ (gestrichelte Linie) und den Amplitudengang der Impedanz $Z_S$ der Simulationseinheit 3 (durchgezogene Linie) abbildet. Hierbei können zwei Phänomene beobachtet werden:

1) Bei niedrigen Frequenzen ist die Quellimpedanz $Z_Q$ leicht erhöht. Dies wird durch den Leitungswiderstand $R_L$ verursacht, der im Wesentlichen über alle Frequenzen konstant ist.

2) Bei hohen Frequenzen steigt die Quellimpedanz $Z_Q$ stark an. Dies wird als hochfrequente Trennung zwischen Simulationseinheit 3 und Prüfling 2 bezeichnet und wird primär durch die Leitungsinduktivität $L_L$ verursacht.

Der durch die Leitungsinduktivität $L_L$ verursachte Anstieg der Quellimpedanz $Z_Q$ kann nicht durch Änderungen im Simulationsmodell korrigiert werden. Wünschenswert wäre, dass die sich dem Prüfling darstellende Quellimpedanz $Z_Q$ der Impedanz der $Z_S$ Simulationseinheit entspricht. Mit anderen Worten: Der Einfluss der Verbindungsleitung 4 soll eliminiert werden und die Quellimpedanz $Z_Q$ soll einem Vorgabewert, beispielsweise einer allgemeinen Impedanz oder der Impedanz $Z_S$ der Simulationseinheit 3, entsprechen. Zu diesem Zweck wird in weiterer Folge auch die Impedanz $Z_S$ der Simulationseinheit 3 angepasst, d.h. verändert, weshalb, wenn die Quellimpedanz $Z_Q$ der Impedanz $Z_S$ der Simulationseinheit 3 entsprechen soll, auch von der ursprünglichen Impedanz $Z_S$ der Simulationseinheit 3 die Rede ist.

Erfindungsgemäß ist eine Kompensationsimpedanz $Z_K$ zur Anpassung der Quellimpedanz $Z_Q$ vorgesehen. Mit Hilfe der Kompensationsimpedanz $Z_K$ kann die sich dem Prüfling 2 darstellende Quellimpedanz $Z_Q$ angepasst, d.h. verändert werden. Dies soll an Hand von Fig. 4 erläutert werden.

Fig. 4 zeigt erneut ein Ersatzschaltbild der erfindungsgemäßen Vorrichtung 1 mit einem angeschlossenen Prüfling 2. In der Verbindungseinheit 5 ist jedoch die erfindungsgemäße Kompensationsimpedanz $Z_K$ vorgesehen. Diese besteht aus einem Kompensationskondensator $C_P$ und einem ohmschen Kompensationswiderstand $R_P$. Der Kompensationskondensator $C_P$ und der Kompensationswiderstand $R_P$ sind elektrisch in Serie geschaltet. Die Kompensationsimpedanz $Z_K$ ist elektrisch parallel zum Prüfling 2 geschaltet. Um auf einfache Weise Anpassungen vornehmen zu können, können der Kompensationskondensator $C_P$ und/oder der Kompensationswiderstand $R_P$ verstellbar ausgebildet sein.

Die aus Sicht des Prüflings 2 gebildete Quellimpedanz $Z_Q$ berechnet sich aus der Parallelschaltung der Kompensationsimpedanz $Z_K$ und der Serienschaltung aus der Leitungsimpedanz $Z_L$ und der Impedanz $Z_S$ der Simulationseinheit 3:

$$Z_Q(s) = \frac{(Z_S(s) + R_L + sL_L)\left(R_P + \frac{1}{sC_P}\right)}{Z_S(s) + R_L + sL_L + R_P + \frac{1}{sC_P}}$$

(Gleichung 1)

Die Variable "s" entspricht hierbei der im allgemeinen komplexen Laplace Variable der Laplace-Transformation. Zur Verdeutlichung, dass es sich bei den Impedanzen $Z_Q$ und $Z_S$ um allgemeine, frequenzabhängige Impedanzen handeln kann, wurde diesen Impedanzen in den Gleichungen die Variable (s) beigefügt. Soll die Quellimpedanz $Z_Q$ einem Vorgabewert $Z_{SOLL}$ entsprechen, muss gelten:

$$Z_{SOLL}(s) = Z_Q(s) = \frac{(Z_S(s) + R_L + sL_L)\left(R_P + \frac{1}{sC_P}\right)}{Z_S(s) + R_L + sL_L + R_P + \frac{1}{sC_P}}.$$

(Gleichung 2)

Gleichung 2 kann auf

$$Z_S(s) = \frac{Z_{SOLL}(s)[s^2 L_L C_P + s(R_L + R_P)C_P + 1] - [s^2 L_L R_P C_P + s(R_L R_P C_P + L_L) + R_L]}{s(R_P - Z_{SOLL}(s))C_P + 1}$$

(Gleichung 3)

umgeformt werden und gibt an, wie bei vorgegebener Quellimpedanz $Z_Q = Z_{SOLL}$ die Impedanz $Z_S$ der Simulationseinheit 3 gewählt werden muss. Gleichung 3 gilt hierbei ganz allgemein für die Impedanz $Z_S$ der Simulationseinheit 3.

Es soll nun vereinfacht vorgesehen sein, dass die Quellimpedanz $Z_Q$ einem konstanten ohmschen Vorgabewiderstand $Z_{SOLL} = R_S$ entsprechen soll. Der Vorgabewiderstand $R_S$ kann beispielsweise jener Wert sein, den das Simulationsmodell für den Prüfling 2 vorgesehen hätte, jedoch auf Grund der Verbindungsleitung 4 verfälscht werden würde. Gleichung 3 lässt sich unter dieser Vorgabe wie folgt umformen:

$$Z_S(s) = \frac{s^2(R_S - R_P)L_L C_P + s[(R_S - R_P)R_L C_P + R_S R_P C_P - L_L] + (R_S - R_L)}{s(R_P - R_S)C_P + 1}.$$

(Gleichung 4)

Auf Grund des höheren Zählergrades (siehe die Laplace Variable s) in Gleichung 4 handelt es sich hierbei um eine nicht realisierbare Impedanz $Z_S$. Wenn nun für $R_P = R_S$ gewählt wird, erhält man

$$Z_S(s) = s(R_S R_P C_P - L_L) + (R_S - R_L),$$

(Gleichung 5)

was allerdings eine noch immer nicht realisierbare Impedanz darstellt. Durch die Wahl

$$C_P = \frac{L_L}{R_S R_P} = \frac{L_L}{R_P^2}$$

(Gleichung 6)

vereinfacht sich Gleichung 5 auf vorteilhafte Weise zu

$$Z_S(s) = (R_S - R_L).$$

(Gleichung 7)

Dies stellt schließlich eine realisierbare Impedanz $Z_S$ der Simulationseinheit 3 dar, welche einem frequenzunabhängigen, ohmschen Widerstand entspricht. Die Impedanz $Z_S$ der Simulationseinheit in Gleichung 6 entspricht dabei dem um den Leitungswiderstand $R_L$ reduzierten Vorgabewiderstand $R_S$. Durch die obige Wahl der Parameter $R_P$ und $C_P$ kann also der Einfluss der Leitungsinduktivität eliminiert werden und es ergibt sich ein besonders einfach zu bildender ohmscher Widerstandswert der Impedanz $Z_S$ der Simulationseinheit 3. Durch die Subtraktion $R_L$ von $R_S$ wird dabei der ohmsche Leitungswiderstand $R_L$ kompensiert.

Die obigen Annahmen und Ergebnisse dienen als Ausführungsbeispiel und können wie folgt zusammengefasst und interpretiert werden: Um die Quellimpedanz $Z_Q$ der Vorrichtung, welche sich dem Prüfling 2 darstellt, derart zu verändern, dass sie einer einem vorgegebenen ohmschen Widerstandswert $R_S$ entspricht, ist es günstig, wenn die Impedanz $Z_S$ der Simulationseinheit 3 dem Widerstandswert $R_S$ - $R_L$ entspricht. Anders formuliert: Die Impedanz $Z_S$ der Simulationseinheit soll dem um den Leitungswiderstand $R_L$ reduzierten Vorgabewiderstand $R_S$ entsprechen. Des Weiteren soll die Kapazität des Kompensationskondensator $C_P$ nach Gleichung 6 gewählt werden und der Kompensationswiderstand $R_P$ dem Vorgabewiderstand $R_S$ entsprechen.

**Patentansprüche**

1. Vorrichtung (1) zum Testen, insbesondere hochfrequenten Testen, eines Prüflings (2), beispielsweise einer elektrischen Maschine oder eines Umrichters, aufweisend:

   - eine Simulationseinheit (3) zur Simulation eines elektrischen Energiespeichers mit Hilfe eines Simulationsmodells und
   - eine elektrische Verbindungsleitung (4), über welche der Prüfling (2) mit der Simulationseinheit (3) verbindbar ist,

   wobei die Vorrichtung (1) eine Kompensationsimpedanz ($Z_K$) zur Kompensation einer Impedanz zufolge einer Leitungsinduktivität ($L_L$) der Verbindungsleitung (4) aufweist, **dadurch gekennzeichnet, dass** die Kompensationsimpedanz ($Z_K$) derart angeordnet ist, dass sie in einem angeschlossenen Zustand des Prüflings elektrisch parallel zum Prüfling (2) angeordnet ist.

2. Vorrichtung (1) nach Anspruch 1, **dadurch gekennzeichnet, dass** die Kompensationsimpedanz ($Z_K$) an einem dem Prüfling (2) zugewandten Ende der Verbindungsleitung (4), vorzugsweise zwischen dem Prüfling (2) zugewandten Ende der Verbindungsleitung (4) und dem Prüfling (2), insbesondere in einer Verbindungseinheit (5), angeordnet ist.

3. Vorrichtung (1) nach einem der Ansprüche 1 oder 2, **dadurch gekennzeichnet, dass** die Kompensationsimpedanz ($Z_K$) einen ohmschen Kompensationswiderstand ($R_P$) und einen Kompensationskondensator ($C_P$) aufweist, wobei der Kompensationswiderstand ($R_P$) und der Kompensationskondensator ($C_P$) vorzugsweise elektrisch in Serie geschaltet sind.

4. Vorrichtung (1) nach Anspruch 3, **dadurch gekennzeichnet, dass** als Kompensationswiderstand ($R_P$) ein verstellbarer Widerstand und/oder dass als Kompensationskondensator ($C_P$) ein verstellbarer Kondensator vorgesehen sind/ist.

5. Vorrichtung (1) nach einem der Ansprüche 3 oder 4, **dadurch gekennzeichnet, dass** die Kompensationsimpedanz ($Z_K$) eine aus einer Leitungsimpedanz ($Z_L$) der Verbindungsleitung (4) und einer Impedanz ($Z_S$) der Simulationseinheit (3) gebildete Quellimpedanz ($Z_Q$) derart anpasst, dass die Quellimpedanz ($Z_Q$) einem ohmschen Vorgabewiderstand ($R_S$) entspricht.

6. Vorrichtung (1) nach Anspruch 5, **dadurch gekennzeichnet, dass** der Wert des Kompensationswiderstands ($R_P$) im Wesentlichen dem Wert des Vorgabewiderstands ($R_S$) entspricht.

7. Vorrichtung (1) nach Anspruch 6, **dadurch gekennzeichnet, dass** die Impedanz ($Z_S$) der Simulationseinheit (3) einem ohmschen Innenwiderstand ($R_I$) entspricht, der gemäß der Formel $R_I = R_S - R_L$ dimensioniert ist, wobei $R_S$ den ohmschen Vorgabewiderstand und $R_L$ einen ohmschen Leitungswiderstand der Verbindungsleitung (4) bezeichnet.

8. Vorrichtung (1) nach einem der Ansprüche 3 bis 7, **dadurch gekennzeichnet, dass** der Kompensationskondensator ($C_P$) gemäß der Formel $C_P = L_L/(R_P^2)$ dimensioniert ist, wobei $L_L$ eine Leitungsinduktivität der Verbindungsleitung (4) und $R_P$ den Kompensationswiderstand bezeichnet.

9. Verfahren zum Testen, insbesondere hochfrequenten Testen, eines Prüflings (2), beispielsweise einer elektrischen Maschine oder eines Umrichters, bei dem der Prüfling (2) über eine elektrische Verbindungsleitung (4) mit einer Simulationseinheit (3) verbunden wird, wobei die Simulationseinheit (3) einen elektrischen Energiespeicher mit Hilfe eines Simulationsmodells simuliert, wobei eine Kompensationsimpedanz ($Z_K$) zur Kompensation einer Impedanz zufolge einer Leitungsinduktivität ($L_L$) der Verbindungsleitung (4) verwendet wird, **dadurch gekennzeichnet, dass** die Kompensationsimpedanz ($Z_K$) elektrisch parallel zum Prüfling (2) angeordnet ist.

## Claims

1. Device (1) for the testing, in particular the high-frequency testing, of a test item (2), for example of an electrical machine or a converter, having:

   - a simulation unit (3) for the simulation of an electrical energy storage with the aid of a simulation model, and
   - an electrical connecting line (4), by way of which the test item (2) can be connected to the simulation unit (3), wherein the device (1) has a compensation impedance ($Z_K$) for the compensation of an impedance resulting from a line inductance ($L_L$) of the connecting line (4),
   **characterised in that**, the compensation impedance ($Z_K$) is arranged such that, in a connected state of the test item, it is electrically arranged in parallel with the test item (2).

2. Device (1) according to Claim 1, **characterised in that**, the compensation impedance ($Z_K$) is arranged at an end of the connecting line (4) facing towards the test item (2), preferably between the end of the connecting line (4) facing towards the test item (2), and the test item (2), in particular in a connecting unit (5).

3. Device (1) according to one of the Claims 1 or 2, **characterised in that**, the compensation impedance ($Z_K$) has an ohmic compensation resistor ($R_P$) and a compensation capacitor ($C_P$), wherein the compensation resistor ($R_P$) and the compensation capacitor ($C_P$) are preferably electrically connected in series.

4. Device (1) according to Claim 3, **characterised in that**, an adjustable resistor is provided as the compensation resistor ($R_P$), and/or **in that**, an adjustable capacitor is provided as the compensation capacitor ($C_P$).

5. Device (1) according to one of the Claims 3 or 4, **characterised in that**, the compensation impedance ($Z_K$) adapts a source impedance ($Z_Q$), formed from a line impedance ($Z_L$) of the connecting line (4) and an impedance ($Z_S$) of the simulation unit (3), such that the source impedance ($Z_Q$) corresponds to a specified ohmic resistance ($R_S$).

6. Device (1) according to Claim 5, **characterised in that**, the value of the compensation resistor ($R_P$) essentially corresponds to the value of the specified resistance ($R_S$).

7. Device (1) according to Claim 6, **characterised in that**, the impedance ($Z_S$) of the simulation unit (3) corresponds to an ohmic internal resistance ($R_I$), dimensioned according to the formula $R_I = R_S - R_L$, wherein $R_S$ denotes the specified ohmic resistance, and $R_L$ denotes an ohmic line resistance of the connecting line (4).

8. Device (1) according to one of the Claims 3 to 7, **characterised in that**, the compensation capacitor ($C_P$) is dimensioned according to the formula $C_P = L_L/(R_P^2)$, wherein $L_L$ denotes a line inductance of the connecting line (4), and $R_P$ denotes the compensation resistor.

9. Method for the testing, in particular the high-frequency testing, of a test item (2), for example of an electrical machine or a converter, in which the test item (2) is connected to a simulation unit (3) by way of an electrical connecting line (4), wherein the simulation unit (3) simulates an electrical energy storage with the aid of a simulation model, wherein a compensation impedance ($Z_K$) is used to compensate for an impedance, resulting from a line inductance ($L_L$) of the connecting line (4), **characterised in that**, the compensation impedance ($Z_K$) is electrically arranged in parallel with the test item (2).

**Revendications**

1. Dispositif (1) pour tester, en particulier tester à haute fréquence, un objet à tester (2), par exemple une machine électrique ou un convertisseur, présentant :

   - une unité de simulation (3) pour la simulation d'un accumulateur d'énergie électrique à l'aide d'un modèle de simulation et
   - une ligne de connexion (4) électrique, par l'intermédiaire de laquelle l'objet à tester (2) peut être connecté à l'unité de simulation (3),

   dans lequel le dispositif (1) présente une impédance de compensation ($Z_K$) pour la compensation d'une impédance résultant d'une inductance de ligne ($L_L$) de la ligne de connexion (4), **caractérisé en ce que** l'impédance de compensation ($Z_K$) est disposée de telle sorte que dans un état raccordé de l'objet à tester elle est disposée électriquement en parallèle par rapport à l'objet à tester (2).

2. Dispositif (1) selon la revendication 1, **caractérisé en ce que** l'impédance de compensation ($Z_K$) est disposée sur une extrémité de la ligne de connexion (4) tournée vers l'objet à tester (2), de préférence entre l'extrémité de la ligne de connexion (4) tournée vers l'objet à tester (2) et l'objet à tester (2), en particulier dans une unité de connexion (5).

3. Dispositif (1) selon l'une quelconque des revendications 1 ou 2, **caractérisé en ce que** l'impédance de compensation ($Z_K$) présente une résistance de compensation ($R_P$) ohmique et un condensateur de compensation ($C_P$), dans lequel la résistance de compensation ($R_P$) et le condensateur de compensation ($C_P$) sont montés de préférence électriquement en série.

4. Dispositif (1) selon la revendication 3, **caractérisé en ce qu'**une résistance réglable en tant que résistance de compensation ($R_P$) et/ou qu'un condensateur réglable en tant que condensateur de compensation ($C_P$) est/sont prévus.

5. Dispositif (1) selon l'une quelconque des revendications 3 ou 4, **caractérisé en ce que** l'impédance de compensation ($Z_K$) adapte une impédance de source ($Z_Q$) formée d'une impédance de ligne ($Z_L$) de la ligne de connexion (4) et d'une impédance ($Z_S$) de l'unité de simulation (3), de telle sorte que l'impédance de source ($Z_Q$) correspond à une résistance prescrite ($R_S$) ohmique.

6. Dispositif (1) selon la revendication 5, **caractérisé en ce que** la valeur de la résistance de compensation ($R_P$) correspond sensiblement à la valeur de la résistance prescrite ($R_S$).

7. Dispositif (1) selon la revendication 6, **caractérisé en ce que** l'impédance ($Z_S$) de l'unité de simulation (3) correspond à une résistance intérieure ohmique ($R_I$), qui est dimensionnée selon la formule $R_I = R_S - R_L$, dans lequel $R_S$ désigne la résistance prescrite ohmique et $R_L$ une résistance de ligne ohmique de la ligne de connexion (4).

8. Dispositif (1) selon l'une quelconque des revendications 3 à 7, **caractérisé en ce que** le condensateur de compensation ($C_P$) est dimensionné selon la formule $C_P = L_L/(R_p^2)$, dans lequel $L_L$ désigne une inductance de ligne de la ligne de connexion (4) et $R_p$ la résistance de compensation.

**9.** Procédé pour tester, en particulier tester à haute fréquence, un objet à tester (2), par exemple une machine électrique ou un convertisseur, selon lequel l'objet à tester (2) est connecté à une unité de simulation (3) par l'intermédiaire d'une ligne de connexion (4) électrique, dans lequel l'unité de simulation (3) simule un accumulateur d'énergie électrique à l'aide d'un modèle de simulation, dans lequel une impédance de compensation ($Z_K$) pour la compensation d'une impédance résultant d'une inductance de ligne ($L_L$) de la ligne de connexion (4) est utilisée, **caractérisé en ce que** l'impédance de compensation ($Z_K$) est disposée électriquement en parallèle par rapport à l'objet à tester (2)

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013174967 A1
- DE 29621472 U1
- KR 100652728 B1
- DE 102012217973 A1
- DE 102011054370 A1

**In der Beschreibung aufgeführte Nicht-Patentliteratur**

- **VON KEITHLEY.** Application Note Series. *Stabilizing Fast Transient Response Power Supply/Load Circuits,* Januar 2007
- Cell Battery Emulator for Hardware-in-the-Loop BMS Test. **LUCA et al.** 2018 IEEE INTERNATIONAL CONFERENCE ON ENVIRON-MENT AND ELECTRICAL ENGINEERING AND 2018 IEEE INDUSTRIAL AND COMMERCTAL POWER SYSTEMS EUROPE (EEEIC / I&CPS EUROPE). IEEE, 12. Juni 2018, 1-5